(19) Europäisches Patentamt

European Patent Office

Office européen des brevets

(11) **EP 0 948 135 B1**

(12) **EUROPEAN PATENT SPECIFICATION**

(45) Date of publication and mention
of the grant of the patent:
**11.08.2004  Bulletin 2004/33**

(51) Int Cl.[7]: **H03K 7/08**

(21) Application number: **98830191.7**

(22) Date of filing: **31.03.1998**

(54) **Generator of pulses with programmable width**

Generator von Pulsen mit programmierbarer Dauer

Générateur d'impulsions programmable en largeur

(84) Designated Contracting States:
**DE FR GB IT**

(43) Date of publication of application:
**06.10.1999  Bulletin 1999/40**

(73) Proprietor: **STMicroelectronics S.r.l.**
**20041 Agrate Brianza (Milano) (IT)**

(72) Inventors:
• **Portaluri, Salvatore**
**27100 Pavia (IT)**
• **Pisati, Valerio**
**27040 Bosnasco (Pavia) (IT)**
• **Zangrandi, Luigi**
**27100 Pavia (IT)**

(74) Representative: **Modiano, Guido, Dr.-Ing. et al**
**Modiano & Associati SpA**
**Via Meravigli, 16**
**20123 Milano (IT)**

(56) References cited:
**DE-B- 2 319 164**        **US-A- 3 713 026**
**US-A- 3 728 635**        **US-A- 4 595 848**
**US-A- 4 968 907**

• **W. KLARA: "SINGLE SHOT CIRCUIT
IMPLEMENTED IN LARGE SCALE
INTEGRATION" IBM TECHNICAL DISCLOSURE
BULLETIN, vol. 20, no. 4, 1 September 1977, page
1458 XP002074613 new york ,us**

## Description

The present invention relates to a device for generating pulses of high-precision programmable duration.

Pulses are conventionally characterized by waveform, duration and repeat period. The waveform that the pulse must have depends on the applications. Some cases may require a perfectly rectangular pulse; in other cases, such as for example in the trigger circuits of an oscilloscope, the waveform is not important but a pulse with short duration and a steep rising edge is necessary.

It may also be necessary to generate the pulses one by one, or generation can occur continuously at a preset frequency; often the duration of the pulse and the repetition rate must be adjustable.

Pulse generation can occur by using differentiating, multivibrator, locked oscillating circuits and delay lines. The most common pulse generation case entails the use of preset time constants (RC circuit, RC cascades or logic gate cascades). Cases requiring good precision use a clock (if available) or the time required by a capacitor to charge under a constant current until a preset threshold voltage is reached.

In this case, the duration of the pulse is determined by the conventional relation:

$$T = C*V/I$$

By choosing a fixed current (for example, by extracting a current from a band-gap voltage divided by an external resistance) and a fixed threshold voltage (K* band-gap voltage), pulse precision is affected only by the variations in the capacitance related to the process.

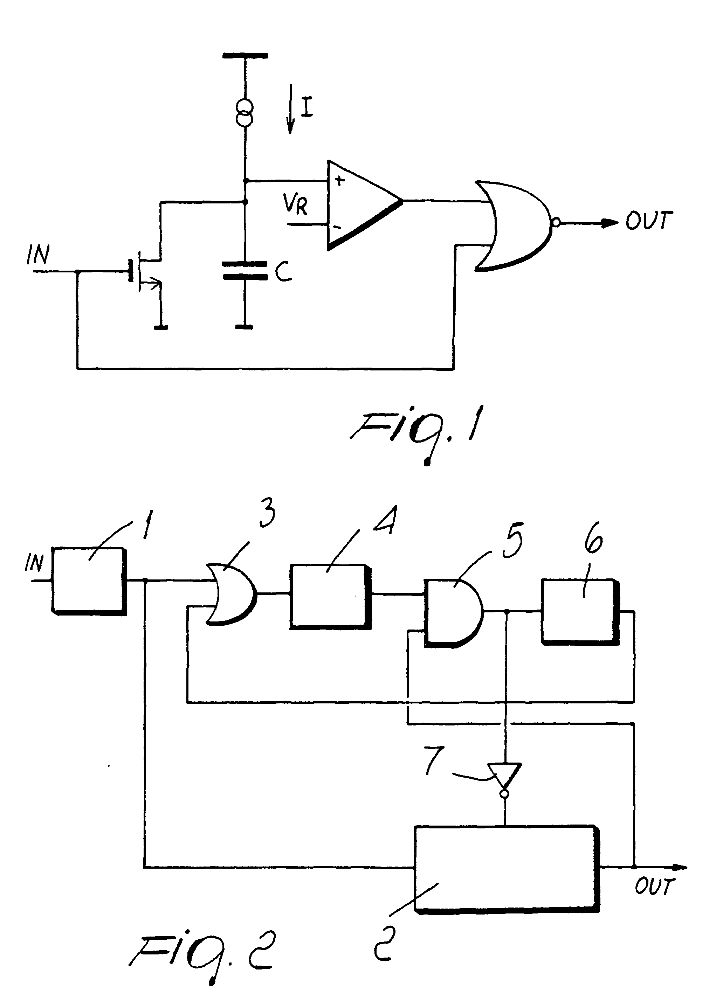

If it is possible to adjust the current so as to follow the capacitance variation, precision is certainly very high by using for example conventional structures such as the one shown in Figure 1.

In this case, the main drawback is the difficulty in generating pulses having a relatively long duration (on the order of 20-100 microseconds) within a chip.

The threshold voltage V is limited to the value of the supply voltage and it is therefore necessary to use an extremely high capacitance value C with very low values of the current I; accordingly, precision is certainly degraded.

The aim of the present invention is to provide a device for generating pulses of high-precision programmable duration which can be synchronized with a pulse start command.

Within the scope of this aim, an object of the present invention is to provide a device for generating pulses of high-precision programmable duration without using an internal clock signal.

Another object of the present invention is to provide a device for generating pulses of high-precision programmable duration usable in circuits for controlling the polarization of a laser in analog-digital applications in which no reference clock signal is present.

Another object of the present invention is to provide a device for generating pulses of high-precision programmable duration which is suitable to provide programmable timers.

Another object of the present invention is to provide a device for generating pulses of high-precision programmable duration which is highly reliable, relatively easy to manufacture and at competitive costs.

This aim, these objects and others which will become apparent hereinafter are achieved by a device for generating pulses of high-precision programmable duration, characterized in that it comprises:

-- first pulse generator means which are suitable to receive in input a pulse generation command signal and to emit in output a first pulse for loading the contents of a register in counter means;
-- second pulse generator means, triggered by the first pulse in output from said first pulse generator means;
-- third pulse generator means, triggered by a second pulse emitted by said second pulse generator means and suitable to generate a third pulse to restart said second pulse generator means;

said second pulse emitted by said second pulse generator means constituting a clock signal for said counter means in order to produce a decrement in said counter means; the signal in output from said counter means being the pulsed signal to be generated; the duration of said pulsed signal being determined by the content of said counter means.

Further characteristics and advantages of the invention will become apparent from the description of a preferred but not exclusive embodiment of the device according to the invention, illustrated only by way of non-limitative example in the accompanying drawings, wherein:

Figure 1 is a circuit diagram of a conventional pulse generator device; and
Figure 2 is a block diagram of the pulse generator device according to the present invention.

Accordingly, Figure 2, which shows the pulse generator device according to the present invention, illustrates first pulse generator means, designated by the reference numeral 1, in which the output is connected to counter means 2 and to first logic means, advantageously provided by an OR logic gate.

The OR logic gate is connected to second pulse generator means 4, in which the output is connected to second logic means, advantageously provided by an AND logic gate 5 in which the output is in turn connected to third pulse generator means 6.

The output of the third pulse generator means 6 is fedback to the OR logic gate 3 and constitutes the second input of the logic gate, in addition to the input from the first pulse generator means 1.

The signal in output from the counter means 2 is sent both to the output as the intended pulse and to the AND logic gate 5 and constitutes the second input of said gate. The first input of the gate is, as mentioned, the output of the second pulse generator means 4.

The signal in output from the AND logic gate is sent not only to the third pulse generator means 6 but also to the counter means 2 after passing through an inverter 7.

The signal in input to the first pulse generator means 1 is a trigger signal, i.e., a signal which commands the start of the pulse, designated by the reference sign IN.

The counter means 2 internally store the content of an external register which determines a value for multiplying the duration of the pulse generated by the second pulse generator means 4.

Therefore, the duration of the pulse is equal to the value loaded in the counter means 2 multiplied by the duration of the pulse generated by the means 4.

With reference now to Figure 2, operation of the device according to the invention is as follows.

First of all, the pulse generation command signal IN is input to the pulse generator means 1, which emit a first pulse defining the signal for loading the counter means 2 with the value contained in an external register. The first pulse is also sent to the first logic means 3, formed by the OR gate, and is used to trigger the second pulse generator means 4 together with the pulse which is fedback by the third pulse generator means 6.

The loading of the counter means 2 allows to set the output of the counter means (which ultimately constitutes the final pulse, designated by OUT) to the logic value "1", thus determining the start of the final pulse OUT.

The falling edge of the pulse generated by the second pulse generator means 4 is provided as the clock signal for the counter means 2 and triggers the third pulse generator means 6, which as shown generate a short pulse (third pulse) which is meant to restart the second pulse generator means 4 by being fed to the OR logic gate.

Operation continues with the counter means 2, which decrease their content upon the arrival of each clock signal; when the value of the count reaches zero, the pulsed output signal OUT is reset, determining the end of the pulse to be generated and also blocking propagation of the clock signal along the chain until a subsequent pulse generation command pulse IN arrives.

In practice, it has been observed that the device according to the invention fully achieves the intended aim and objects, since it allows to generate a pulse having a duration programmable with high precision, without using large capacitance values with very small current values. The device according to the invention is particularly suitable for use in all analog-digital applications in which a reference clock signal is not present.

Moreover, the device is suitable for the production of programmable timers and for generating a pulse for the test phase of a circuit for controlling the polarization of a laser in DVD applications.

The device thus conceived is susceptible of numerous modifications and variations, all of which are within the scope of the inventive concept; all the details may also be replaced with other technically equivalent elements.

In practice, the materials employed, so long as they are compatible with the specific use, as well as the dimensions, may be any according to requirements and to the state of the art.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A device for generating pulses of high-precision programmable duration, **characterized in that** it comprises:

   -- first pulse generator means (1) which are suitable to receive in input a pulse generation command signal (in) and to emit in output a first pulse for loading the contents of a register in counter means (2);

   -- second pulse generator means (4), triggered by the first pulse in output from said first pulse generator means (1);

   -- third pulse generator means (6), triggered by a second pulse emitted by said second pulse generator means (4) and suitable to generate a third pulse to restart said second pulse generator means (4);

   said second pulse emitted by said second pulse generator means (4) constituting a clock signal for said counter means (2) in order to produce a decrement in said counter means (2); the signal in output (OUT) from said counter means (2) being the pulsed signal to be generated; the duration of said pulsed signal being determined by the content of said counter means (2).

2. A device according to claim 1, **characterized in that** it comprises first logic means (3) which are interposed between said first pulse generator means (1) and said second pulse generator means (4), a first input of said first logic means being constituted by said first pulse, a second input being constituted by said third pulse.

3. A device according to claim 1, **characterized in that** it comprises second logic means (5) which are interposed between said second (4) and third (6) pulse generator means, a first input of said second logic means being constituted by said second pulse, a second input being constituted by the pulsed signal emitted by said counter means (2).

4. A device according to claim 2, **characterized in that** said first logic means (3) comprise an OR logic gate.

5. A device according to claim 3, **characterized in that** said second logic means (5) comprise an AND logic gate.

6. A device according to claim 5, **characterized in that** it comprises an inverter (7) which is arranged between said AND logic gate and said counter means (2).

7. A method for generating a pulse having high-precision programmable duration, **characterized in that** it comprises the steps of:

   triggering first pulse generator means (1) which are suitable to generate a first pulse which loads the contents of a register into counter means (2), the pulsed output signal of said counter means (2) constituting the intended programmable-duration pulse;
   triggering second pulse generator means (4) by means of said first pulse, in order to generate a second pulse which constitutes a clock signal for said counter means (2);
   producing a decrement in said counter means (2) following the sending of said clock signal; and
   triggering third pulse generator means (6) by means of said second pulse, in order to generate a third pulse which is suitable to restart said second pulse generator means (4);
   the duration of said pulsed signal in output from said counter means (2) being determined by the content of said register loaded in said counter means (2).

8. A method according to claim 7, **characterized in that** said first pulse and said third pulse are input to first logic means (3) which are interposed between said first pulse generator means (1) and said second pulse generator means (4).

9. A method according to claim 7, **characterized in**

**that** said second pulse and the pulsed output signal of said counter means are input to second logic means (5) which are interposed between said second pulse generator (4) means and said third pulse generator means (6), said second logic means emitting said clock signal.

10. A method according to claim 7, **characterized in that** said clock signal is input to said counter means after passing through inverter means (7),

11. A method according to claim 7, **characterized in that** the step that consists in triggering said first pulse generator means (1) is provided by means of a pulse generation command signal (IN) which is input to said first pulse generator means (1).

12. A method according to claim 11, **characterized in that** when the content of said counter means (2) is decremented, at each clock signal, down to zero, said pulsed signal in output from the counter means is reset, determining the end of the intended pulse and blocking the propagation of said clock signal until a new pulse generation command signal (in) arrives.

**Patentansprüche**

1. Vorrichtung zur Erzeugung von Impulsen von hochpräzise programmierbarer Dauer,
   **dadurch gekennzeichnet, dass** sie aufweist:

   - erste Impulserzeugungsmittel (1), die geeignet sind, um am Eingang ein Impulserzeugüngsbefehlssignal (IN) zu empfangen und am Ausgang einen ersten Impuls zum Laden der Inhalte eines Registers in Zellmittel (2) abzugeben;
   - zweite Impulserzeugungsmittel (4), die vom ersten Impuls am Ausgang von den ersten Impulserzeugungsmitteln (1) getriggert werden;
   - dritte Impulserzeugungsmittel (6), die von einem von den zweiten Impulserzeugungsmitteln (4) abgegebenen zweiten Impuls getriggert werden und geeignet sind, einen dritten Impuls zu erzeugen, um die zweiten Impulserzeu, gungsmittel (4) wieder zu starten;

   wobei der von den zweiten Impulserzeugungsmitteln (4) abgegebene zweite Impuls ein Taktsignal für die Zählmittel (2) bildet, um ein Dekrement in den Zählmitteln (2) zu erzeugen, wobei das Signal am Ausgang (OUT) von den Zählmitteln (2) das zu erzeugende gepulste Signal ist, wobei die Dauer des gepulsten Signals vom Inhalt der Zählmittel (2) bestimmt wird.

2. Vorrichtung nach Anspruch 1,

**dadurch gekennzeichnet, dass** sie erste Logikmittel (3) aufweist, die zwischen den ersten Impulserzeugungsmitteln (1) und den zweiten Impulserzeugungsmitteln (4) geschaltet sind, wobei ein erstes Eingangssignal der ersten Logikmittel vom ersten Impuls gebildet wird, wobei ein zweites Eingangssignal vom dritten Impuls gebildet wird.

3. Vorrichtung nach Anspruch 1,
**dadurch gekennzeichnet, dass** sie zweite Logikmittel (5) aufweist, die zwischen den zweiten (4) und dritten (6) Impulserzeugungsmitteln geschaltet sind, wobei ein erstes Eingangssignal der zweiten Logikmittel vom zweiten Impuls gebildet wird, wobei ein zweites Eingangssignal von dem von den Zellmitteln (2) abgegebenen gepulsten Signal gebildet wird.

4. Vorrichtung nach Anspruch 2,
**dadurch gekennzeichnet, dass** die ersten Logikmittel (3) ein ODER-Logikgatter aufweisen.

5. Vorrichtung nach Anspruch 3,
**dadurch gekennzeichnet, dass** die zweiten Logikmittel (5) ein UND-Logikgatter aufweisen.

6. Vorrichtung nach Anspruch 5,
**dadurch gekennzeichnet, dass** sie einen Inverter (7) aufweist, der zwischen dem UND-Logikgatter und den Zellmitteln (2) angeordnet ist.

7. Verfahren zur Erzeugung eines Impulses mit hochpräzise programmierbarer Dauer,
**dadurch gekennzeichnet, dass** es die Schritte aufweist:

die ersten Impulserzeugungsmittel (1) zu triggern, die geeignet sind, einen ersten Impuls zu erzeugen, welcher die Inhalte eines Registers in die Zählmittel (2) lädt, wobei das gepulste Ausgangssignal der Zählmittel (2) den beabsichtigten Impuls mit programmierbarer Dauer bildet;
die zweiten Impulserzeugungsmittel (4) mittels des ersten Impulses zu triggern, um einen zweiten Impuls zu erzeugen, der ein Taktsignal für die Zählmittel (2) bildet;
ein Dekrement in den Zählmitteln (2) nach Übertragung des Taktsignals zu erzeugen; und
die dritten Impulserzeugungsmittel (6) mittels des zweiten Impulses zu triggern, um einen dritten Impuls zu erzeugen, der geeignet ist, die zweiten Impulserzeugungsmittel (4) wieder zu starten;

wobei die Dauer des gepulsten Signals am Ausgang von den Zählmitteln (2) durch den in die Zählmittel (2) geladenen Inhalt des Registers bestimmt wird.

8. Verfahren nach Anspruch 7,
**dadurch gekennzeichnet, dass** der erste Impuls und der dritte Impuls in die ersten Logikmittel (3) eingegeben werden, welche zwischen den ersten Impulserzeugungsmitteln (1) und den zweiten Impulserzeugungsmitteln (4) geschaltet ist.

9. Verfahren nach Anspruch 7,
**dadurch gekennzeichnet, dass** der zweite Impuls und das gepulste Ausgangssignal der Zählmittel in die zweiten Logikmittel (5) eingegeben werden, die zwischen den zweiten Impulserzeugungsmitteln (4) und den dritten Impulserzeugungsmitteln (6) geschaltet sind, wobei die zweiten Logikmittel das Taktsignal abgeben.

10. Verfahren nach Anspruch 7,
**dadurch gekennzeichnet, dass** das Taktsignal in die Zählmittel eingegeben wird, nachdem es durch Invertermittel (7) geleitet worden ist.

11. Verfahren nach Anspruch 7,
**dadurch gekennzeichnet, dass** der Schritt, der aus dem Triggem der ersten Impulserzeugungsmittel (1) besteht, mit Hilfe eines Impulserzeugungsbefehlssignals (IN) durchgeführt wird, welcher in die ersten Impulserzeugungsmittel (1) eingegeben wird.

12. Verfahren nach Anspruch 11,
**dadurch gekennzeichnet, dass**, wenn der Inhalt der Zählmittel (2) bei jedem Taktsignal schrittweise nach unten auf null verringert wird, das gepulste Signal am Ausgang von den Zählmitteln zurückgesetzt wird, um das Ende des beabsichtigten Impulses zu bestimmen und die weitere Übertragung des Taktsignals zu blockieren, bis ein neues ImpuJserzeugungsbefehlssignal (IN) eintrifft.

## Revendications

1. Dispositif de génération d'impulsions de durée programmable avec une haute précision, **caractérisé en ce qu'**il comprend :

un premier moyen générateur d'impulsions (1) adapté à recevoir un signal de commande de génération d'impulsions (IN) et à fournir une première impulsion pour charger le contenu d'un registre dans un moyen de compteur (2) ;
un deuxième moyen générateur d'impulsions (4) déclenché par la première impulsion de sortie du premier moyen générateur d'impulsions (1) ;
un troisième moyen générateur d'impulsions (6) déclenché par une seconde impulsion émise par le deuxième moyen générateur d'impulsions (4) et propre à produire une troisième impulsion pour redéclencher le deuxième moyen générateur d'impulsions (4) ;

la deuxième impulsion émise par le deuxième moyen générateur d'impulsions (4) constituant un signal d'horloge pour le moyen de compteur (2) de façon à produire une décrémentation du moyen de compteur (2) ; le signal de sortie (OUT) du moyen de compteur (2) étant le signal en impulsion à produire ; la durée du signal en impulsion étant déterminée par le contenu du moyen de compteur (2).

2. Dispositif selon la revendication 1, **caractérisé en ce qu'**il comprend un premier moyen logique (3) interposé entre le premier moyen générateur d'impulsions (1) et le deuxième moyen générateur d'impulsions (4), une première entrée du premier moyen logique étant constituée de la première impulsion, une seconde entrée étant constituée de la troisième impulsion.

3. Dispositif selon la revendication 1, **caractérisé en ce qu'**il comprend un deuxième moyen logique (5) interposé entre les deuxième (4) et troisième (6) moyens générateurs d'impulsions, une première entrée du deuxième moyen logique étant constituée de la seconde impulsion, une seconde entrée étant constituée du signal en impulsion émis par le moyen de compteur (2).

4. Dispositif selon la revendication 2, **caractérisé en ce que** le premier moyen logique (3) comprend une porte logique OU.

5. Dispositif selon la revendication 3, **caractérisé en ce que** le deuxième moyen logique (5) comprend une porte logique ET.

6. Dispositif selon la revendication 5, **caractérisé en ce qu'**il comprend un inverseur (7) disposé entre la porte logique ET et le moyen de compteur (2).

7. Procédé de génération d'une impulsion ayant une durée programmable avec une haute précision, **caractérisé en ce qu'**il comprend les étapes suivantes :

déclencher un premier moyen générateur d'impulsions (1) adapté à produire une première impulsion qui charge le contenu d'un registre dans un moyen de compteur (2), le signal de sortie en impulsion du moyen de compteur (2) constituant l'impulsion de durée programmable recherchée ;

déclencher un deuxième moyen générateur d'impulsions (4) par la première impulsion, de façon à produire une deuxième impulsion qui constitue un signal d'horloge pour le moyen de compteur (2) ;

produire une décrémentation dans le moyen de compteur (2) après l'envoi du signal d'horloge ; et

déclencher un troisième moyen générateur d'impulsions (6) au moyen de la deuxième impulsion, pour produire une troisième impulsion qui est propre à redéclencher le deuxième moyen générateur d'impulsions (4) ;

la durée du signal en impulsion de sortie du moyen de compteur (2) étant déterminée par le contenu du registre chargé dans le moyen de compteur (2).

8. Procédé selon la revendication 7, **caractérisé en ce que** la première impulsion et la troisième impulsion sont envoyées à un premier moyen logique (3) interposé entre le premier moyen générateur d'impulsions (1) et le deuxième moyen générateur d'impulsions (4).

9. Procédé selon la revendication 7, **caractérisé en ce que** la deuxième impulsion et le signal de sortie en impulsion du moyen de compteur sont envoyés à un deuxième moyen logique (5) interposé entre le deuxième moyen générateur d'impulsions (4) et le troisième moyen générateur d'impulsions (6), le deuxième moyen logique émettant le signal d'horloge.

10. Procédé selon la revendication 7, **caractérisé en ce que** le signal d'horloge est envoyé au moyen de compteur après passage par un moyen inverseur (7).

11. Procédé selon la revendication 7, **caractérisé en ce que** l'étape qui consiste à déclencher le premier moyen générateur d'impulsions (1) est assurée par un signal de commande de génération d'impulsions (IN) qui est envoyé au premier moyen générateur d'impulsions (1).

12. Procédé selon la revendication 11, **caractérisé en ce que**, quand le contenu du moyen de compteur (2) est décrémenté à chaque signal d'horloge jusqu'à zéro, le signal en impulsion en sortie du moyen de compteur est remis à zéro, déterminant la fin de l'impulsion recherchée et bloquant la propagation du signal d'horloge jusqu'à ce qu'un nouveau signal de commande de génération d'impulsions (IN) arrive.

Fig. 1

Fig. 2